# EUROPEAN PATENT SPECIFICATION

(11) **EP 3 496 249 B1**
(45) Date of publication and mention of the grant of the patent: **04.01.2023**
(21) Application number: 17205434.8
(22) Date of filing: 05.12.2017
(51) Int. Cl.: H02M 1/32, H02M 1/08, H02M 7/5387, H03K 17/06, H03K 17/082, H03K 17/0414

(54) **INVERTER, ASSEMBLY AND VEHICLE COMPRISING SUCH INVERTER, AND METHOD FOR OPERATING AN INVERTER**
WECHSELRICHTER, ANORDNUNG UND FAHRZEUG MIT SOLCH EINEM WECHSELRICHTER UND VERFAHREN ZUM BETRIEB EINES WECHSELRICHTERS
ONDULEUR, ENSEMBLE ET VÉHICULE COMPORTANT UN TEL ONDULEUR ET PROCÉDÉ DE FONCTIONNEMENT D'UN ONDULEUR

(43) Date of publication of application: 12.06.2019
(73) Proprietor: Valeo eAutomotive Germany GmbH, 91056 Erlangen (DE)
(72) Inventor: BOHLLÄNDER, Marco, 96114 Hirschaid (DE)
(74) Representative: Valeo Powertrain Systems

(56) References cited:
- EP-A2- 2 747 260
- DE-A1-102012 002 023
- US-A1- 2016 149 515
- US-A1- 2017 093 323

## Description

The invention relates to an inverter, in particular for an electric machine, an assembly comprising the inverter and an electric machine, a vehicle comprising such assembly, and a method for operating an inverter.

EP 2 747 260 A2 discloses a method for operating an electrical power rectifier, comprising at least two branches that are connected in parallel to each other, each of said branches comprising at least two power semiconductor elements connected in series. The collector-emitter voltage V_{CE}(t) and/or the collector current lc(t) of at least one of the power semiconductor elements is detected, wherein it is determined whether at least one of the following conditions is met: dV_{CE}(t)/dt < (dV_{CE}/dt)_{crit} and/or dlc(t)/dt < (dlc/dt)_{crit} and/or lc(t_ent + delta t) < lc_{crit}. If at least one of the aforementioned conditions is met, the gate-emitter voltage of at least one of the power semiconductor elements is increased being great enough to prevent a desaturation of an affected power semiconductor element. In case of a load short circuit, a symmetrization of the short circuit currents is achieved with the aid of the increase of the gate-emitter voltage. Between the collector and the gate of at least one of the power semiconductor elements, a switch and a circuit are connected, with the aid of which the gate-emitter voltage of the power semiconductor element can be increased.

US 2016/0149515 A1 discloses a gate driver circuit for a power transistor, the gate drive circuit comprising: a capacitor, a first terminal of the first capacitor being electrically coupled to a gate terminal of the power transistor and a switch being arranged between a second terminal of the first capacitor and a first predetermined voltage.

An inverter for an electric machine, comprising a plurality of voltage-controlled switching elements and a controller with a pulsing unit configured to control the switching elements to provide a multiphase AC output in a pulsing mode of the switching elements and with an active region detection unit configured to detect an operation of a switching element in an active region, is widely known in the art.

Such inverters are typically used to convert a DC voltage into a single- or multiphase AC voltage. With respect to electric vehicles, such as battery electric vehicles (BEV) or hybrid electric vehicles, the inverter typically converts a DC voltage provided by a high voltage battery into a three-phase AC current for supplying stator windings of an electric machine driving the vehicle. The inverter comprises switching elements with a switching path connected to a DC link, and a controller with a pulsing unit providing, signals, particularly pulse width modulated signals, according to which the switching elements are controlled. Due to high currents flowing through the switching path, a switching element may unintendedly be operated in an active region, where a current flowing through the switching path depends substantially on a voltage applied to a control terminal of the switching element. As an operation in the active region might damage the switching element, it is known to provide an active region detection unit to the controller. Conventional inverters are configured to switch all switching elements to a blocking switching state in the case of a detected operation in the active region in order to avoid a damage.

However, a switching configuration in which all switching elements are in the blocking state corresponds to a safe pulse off mode (SPO). Particularly with respect to automotive application, a safe pulse off mode may not match all safety requirements. Exemplarily, high braking torques at high rates of rotation may result from adopting the safe pulse off mode.

Thus, it is an object of the invention to avoid these disadvantages, particularly to provide a possibility to operate an inverter more robustly with respect to the handling of an operation of a switching element in the active region.

The above object is solved by the features of claims 1, 2, 12, 13, 14 and 15. Embodiments of the invention are defined by the features of the dependent claims.

According to a first aspect of the invention, an inverter according to claim 1 is provided.

According to a second aspect of the invention, an inverter according to claim 2 is provided.

The invention is based upon the consideration to provide the active short circuit mode (ASC) as safety measure if an undesired operation of a switching element in the active region is observed. Thus, the invention suggests to use the active short circuit for self-protecting the inverter in the case of an operation of a switching element in the active region. In comparison to the safe pulse off mode, an active short circuit allows avoids high braking torques when adopted at a high rate of rotation and thus allows a more robust operation of the inverter. Additionally, an accidental triggering of the short circuit unit by the active region detection unit has no influence on the functional safety of the inverter as an active short circuit is commonly considered as a safe state.

In the context of the invention term "active short circuit" refers to a switching configuration, in which all phases are short-circuited inside the inverter, as well as to a switching configuration, in which only a part of the phases, particularly n-1 phases of n phases, is short-circuited inside the inverter. The switching elements may be insulated gate bipolar transistors (IGBT), insulated gate field-effect transistors, such as metal oxide semiconductor field-effect transistors (MOSFET), or junction field-effect transistors (JFET).

With respect to IGBT as switching elements the active region may be considered as a desaturated region of an output characteristic. With respect to insulated gate field-effect transistors and JFET as switching elements the active region may be considered as a saturation region of an output characteristic. Particularly, if the switching element is not operated in the active region an IGBT is operated in a saturated region of the output characteristics when being conducting and/or an insulated gate filed-effect transistor or a JFET is operated in a linear region (also known as triode region) of the output characteristics when being conducting. The active region may be considered as a region of the output characteristics, in which a current flowing through a switching path of the switching element depends substantially on a voltage applied to a control terminal of the switching element.

The partial active short circuit may be adopted when a corresponding switching configuration is applied to two half bridges in the case of a three-phase AC output. Although a full active short-circuited is preferred, an adequate safety level may be reached with a partial active short circuit as well.

According to the invention, the short circuit unit is configured to switch the switching element, for which an operation in the active region has been detected, to a blocking switching state. With other words switching the switching element to the blocking switching state has priority over switching the switching element to the switching state provided for adopting a full active short circuit. Thus, if the switching element is connected to the potential of the DC link, for which the switching configuration provides the blocking switching state, a full active short circuit is achieved. If the switching element is connected to the potential of the DC link, for which the switching configuration provides the conducting switching state, switching the switching element to a blocking state results in a partial active short circuit. This allows an effective self-protection of the inverter going along with an adequate level of functional safety in the case of the operation in the active region. Particularly, the switching element, for which the operation in the active region has been detected, may be switched to the blocking state after a full active short circuit has been adopted. This allows a protection for the case that the operation in the active region occurs in the active short circuit mode.

Besides, the controller may be configured to override, ignore or inhibit signals from the pulsing unit when the short circuit unit is triggered to put the switching elements into the active short circuit mode. This means, that the signals of the short circuit unit providing the active short circuit may be prioritized over the signals from the pulsing unit in a normal, i.e. failure-free and/or non-active-region, operation of the inverter.

By setting the value of the voltage to the second value according to the invention, the operation in the active region of the switching elements may be avoided as a switching element's operating point is shifted to remain outside the active region even if the high transient currents flow through the switching path. Thus, an even higher level of functional safety is achievable.

The second absolute value may be at least 5 %, particularly at least 10 %, higher than the first absolute value. Assuming a typical first absolute value of about 15 volts, the second absolute value is exemplarily chosen to 17 volts. The specific absolute values may be chosen by a person skilled in the art depending on the operational characteristics, particularly the output characteristics, of the switching elements.

Preferably, the control terminal of each switching element designated to be conducting in the active short circuit mode is connected to a boosting unit comprising an energy source connectable to the control terminal for providing the voltage with the second absolute value. Thus, the boosting unit may be controllable by the short circuit unit to be triggered when the voltage with the second value is to be applied.

Particularly, the energy source comprises an energy storage chargeable to an amount of charge for reaching the second absolute value on the control terminal. The energy storage may be a capacitor. It is preferred, that the energy storage is dimensioned such that a capacity of the control terminal, particularly a gate capacity, with a certain capacitance being charged to the first absolute value may be charged to the second absolute value. The energy storage may further be dimensioned such that the second absolute value may be held for a predefined time span, e.g. for 500 milliseconds. After the time span, the high transient currents of typically decay to a value that allows a switching element to be in the conducting switching state by applying the voltage with the first absolute value without entering the active region.

Furthermore, the boosting unit may comprise a switch configured to connect the energy source to the control terminal when putting the switching elements in the active short circuit mode. The switch may be controlled by the short circuit unit. The switch may be controlled to be closed at least for the time span, within which the application of the voltage with the second absolute value is applied. Afterwards, the switch may remain closed or be opened.

Preferably, the control terminal is connected to a driver unit, wherein the driver unit is configured to amplify the signals from the pulsing unit, wherein the energy source is connectable to a node between the driver unit and the control terminal. The driver unit may comprise a diode connected to the control terminal side of the driver unit and allowing a current to flow into the control terminal. The active region detection unit may be realized as an integral part of each driver unit.

With respect to the inverter according to the invention, it is preferred that the controller comprises a failure detection unit configured to detect a failure state of the inverter and to trigger the short circuit unit to put the switching elements into the active short circuit mode if a failure is detected. Generally, an operation of a switching element in the active region is not considered as a failure state. The failure may be an increase of the DC link voltage over predefined threshold value. When adopting the active short circuit mode, both switching elements of a half bridge may be conducting for a short time (bridge short circuit) due to signal delays and/or latency times. In this case an operation of a switching element in the active region may occur. As the inverter according to the invention provides an active short circuit mode in the case of the operation in the active region, an undesired safe pulse off mode is advantageously avoided when after failure detection the operation in the active region occurs.

According to a third aspect of the invention, an assembly according to claim 12 is provided.

According to a fourth aspect of the invention, a vehicle according to claim 13 is provided.

According to a fifth aspect of the invention, a method according to claim 14 is provided.

According to a sixth aspect of the invention, a method according to claim 15 is provided.

All statements referring to the inventive inverters apply analogously to the inventive assembly, the inventive vehicle and the inventive methods, so that the above-mentioned advantages of the inventive inverters may be achieved as well.

Further details and advantages of the invention are disclosed in the following, whereby reference is made to the schematic drawings showing:
Fig. 1 a schematic diagram of an embodiment of an assembly according to the invention with an inverter according to the first aspect of the invention;
Fig. 2 a schematic diagram of a driver unit and a boosting unit connected to a switching element of the inverter depicted in Fig. 1;
Fig. 3 a characteristic output curve of a switching element of the inverter depicted in Fig. 1; and
Fig. 4 a schematic drawing of a vehicle according to the invention.

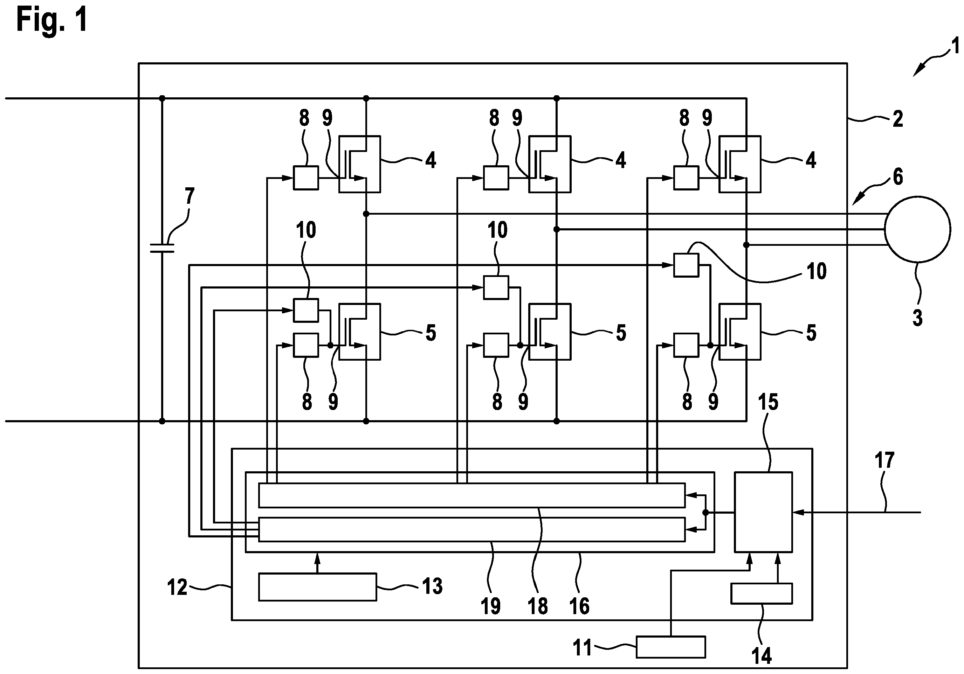

Fig. 1 is a schematic diagram of an embodiment of an assembly 1 comprising an electric machine 3 having a stator with stator windings, and an inverter 2, wherein the inverter 2 is configured to supply the stator windings of the electric machine 3 with a multiphase AC voltage, here a three-phase AC voltage, exemplarily. The electric machine 3 may be a permanent-magnet synchronous machine.

The inverter 2 comprises a plurality of switching elements 4, 5 arranged in a half bridge for each phase of an AC output 6. The switching elements 4 are connected to a high potential of a DC link with a capacitor 7 of the inverter 2, and the switching elements 5 are connected to a low potential of the DC link. The switching elements 4, 5 may be insulated gate bipolar transistors (IGBT), insulated gate field-effect transistors, particularly insulated gate metal oxide semiconductor field-effect transistors (MOSFET), or junction field-effect transistors (JFET).

Furthermore, the inverter 2 comprises number of driver units 8 corresponding to the number of switching elements 4, 5, wherein each control terminal 9, particularly a gate terminal, of the switching element 4, 5 is connected to a driver unit 8. Additionally, the inverter 2 comprises a number of boosting units 10 corresponding to the number of the switching elements 5 connected to the low potential of the DC link. Each control terminal 9 of the switching elements 5 is connected in parallel to a boosting unit 10 to the driver unit 8.

Additionally, the inverter 2 comprises an active region detection unit 11, connected to each switching element 4, 5, wherein the wiring therebetween is not shown in Fig. 1 for reasons of simplicity. The active region detection unit 11 is thus configured to detect an operation of a switching element 4, 5 in an active region, i.e. a desaturation in the case of IGBT as switching elements 4, 5 or an operation in a saturated region of an insulated gate field-effect transistor or a JFET as switching element 4, 5, respectively. The active region detection unit 11 is realized as an integral part of the driver units 8.

Moreover, the inverter 2 comprises a controller 12 with a pulsing unit 13, a failure detection unit 14, a command encoding unit 15 and a short circuit unit 16. The pulsing unit 13 is configured to provide signals, in particular pulse width modulated signals, to the short circuit unit 16. The failure detection unit 14 is configured to detect a failure of the inverter 2, such as an overvoltage in the DC link, and connected to the command encoding unit 15 as well. Furthermore, the command encoding unit 15 is connected to the active region detection unit 11 and is configured to obtain an external signal 17. Note, that the functions of the pulsing unit 13, the failure detection unit 14, the command encoding unit 15 and the short circuit unit 16 may be implemented in one or more pieces of control hardware, e.g. a microcontroller or other control circuitry. Particularly, the implementation may be functionally distributed over several pieces of control hardware. Thus, a respective unit may be a section of a program being implemented.

The short circuit unit 16 comprises a short circuit enforcement unit 18 and a boosting triggering unit 19 each connected to the command encoding unit 15. Therein, the short circuit enforcement unit 18 is connected to each driver unit 8, whereas the boosting triggering unit 19 is connected to each boosting unit 10.

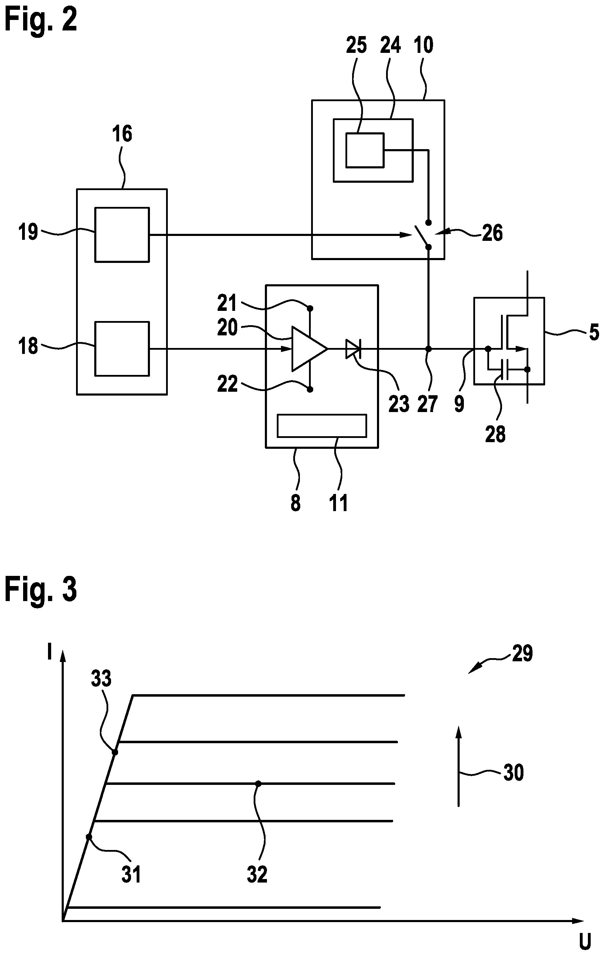

Fig. 2 is a schematic diagram of the driver unit 8 and the boosting unit 10 connected to one of the switching elements 5 representative for all switching elements 5. The circuitry of the switching element 5 and the driver unit 8 depicted in Fig. 2 is representative for the circuitry of each switching element 4 connected in series with the driver unit 8 as well.

The driver unit 8 comprises a driver element 20 configured to amplify the control signal obtained from the short circuit enforcement unit 18 and comprises ports 21, 22 each connected to a voltage supply. Additionally, the driver unit 8 comprises a diode 23 allowing a current to flow from the driver element 20 to the control terminal 9. The boosting unit 10 comprises an energy source 24 with an energy storage 25, such as a capacitor, and a switch 26. The switch 26 is controllable by the boosting triggering unit 19 and configured to connect in a closed state the energy source 24 to a node 27 between the driver unit 8 and the control terminal 9. Additionally, Fig. 2 shows a gate capacity 28 of the switching element 5 and the connection between the switching element 5 and the active region detection unit 11.

In a pulsing mode of the switching elements of 4, 5 the pulsing unit 13 provides its signals, in particular pulse width modulated signals, to the short circuit unit 16, which is configured to pass these signals and to feed them to the driver units 8 for amplifying the signals from the pulsing unit 13. By the amplified signals, the switching elements 4, 5 are switched between a conducting switching state and a blocking switching state for generating the AC output voltage at the AC output 6.

If the active region detection unit 11 detects the operation of a switching element 4, 5 in the active region, or the failure detection unit 14 detects the failure according to a predefined failure condition, the respective unit provides a control signal to the command encoding unit 15. On receiving the control signal or the external signal 17 the command encoding unit 15 provides a control signal to the short circuit unit 16 which is configured to transfer the switching elements 4, 5 from the pulsing mode into an active short circuit mode. Thereby, the short circuit unit 16 inhibits the signals obtained from the pulsing unit 13, and the short circuit enforcement unit 18 provides control signals to the driver units 8 causing the switching elements 4, 5 to adopt an active short circuit mode.

In general, the active short circuit is a full active short circuit being a switching configuration, in which the switching elements 4 are in the blocking switching state and the switching elements 5 are in the conducting switching state. The full active short circuit is provided by the short circuit enforcement unit 18, if a failure has been detected by the failure detection unit 14 or the external signal 17 has been received. As the short circuit enforcement unit 18 is furthermore configured to switch the switching element 4, 5, for which the operation in the active region has been detected, to the blocking switching state, a full active short-circuited is adopted if the active region detection unit 11 detects the operation in the active region of one of the switching elements 4 connected to the high potential of the DC link.

However, if the active region detection unit 11 detects the operation in the active region of one of the switching elements 5 connected to the low potential of the DC link, a partial active short circuit is provided by the short circuit enforcement unit 18. This means that only the switching elements 4 being part of two half bridges are in the blocking switching state, and the switching elements 5 being part of the half bridges are in the conducting switching state, whereas the switching elements 4, 5 of the half bridge having the switching element 5, for which the operation in the active region has been detected, are both in the blocking switching state. Additionally, the short circuit enforcement unit 18 provides a partial active short circuit if the operation of a switching element 5 in the active region is detected after a full active short circuit has been adopted by the switching elements 4, 5. Then the short circuit enforcement unit 18 transfers the switching elements 4, 5 from a full active short circuit mode into a partial active short circuit mode by switching the switching element 5, for which the operation in the active region has been detected, to the blocking switching state. In summary, the short circuit enforcement unit 18 is configured to prioritize the blocking of the switching element 4, 5, for which the operation in the active region has been detected, over switching the switching element 4, 5 into the conducting switching state to achieve the full short circuit mode.

Although an adequate level of functional safety and self-protection is achieved in the partial active short circuit mode, it is preferred to avoid the operation of a switching element 4, 5 in the active region as far as possible. Therefore, the boosting triggering unit 19 is configured to provide a control signal to the boosting units 10 upon receiving the control signal provided by the command encoding unit 15.

The control signal provided by the boosting triggering unit 19 causes the switch 26 to close. Then the energy source 24 is connected to the node 27 and the control terminal 9. As long as the switch 26 is open a voltage with a first absolute value for switching the switching element 5 to the conducting state is provided by the driver element 20 depending on the voltage supply connected to the port 21. When closing the switch 26, the energy source 24 provides a voltage for the second absolute value being higher than the first absolute value to the control terminal 9. Therefore, the energy storage 25 is chargeable to an amount of charge for reaching the second absolute value of the control terminal by charging the gate capacity 28.

Fig. 3 is a characteristic output curve 29 of the switching element 4, 5 depicting a current I flowing through the switching path of the switching element 4, 5 over a voltage U dropping over the switching path depending on a voltage provided to the control terminal 9 (represented by an arrow 30). Thereby, the curve refers to the characteristic output of an IGBT and may apply analogously the characteristic output of an insulated gate field-effect transistor of a JFET.

In the pulsing mode the conducting switching state corresponds to an operating point 31 outside the active region, i.e. the operation point 31 is in a saturation region of an IGBT or in a linear region of an insulated gate field-effect transistor or a JFET, respectively, of the switching element 4, 5. However, when putting the switching elements 4, 5 in the active short circuit mode high transient currents may flow through the switching path which may cause the switching element 5 to be operated at an operating point 32 in the active region. To prevent the operation in the active region, applying the voltage with the second absolute value allows an operation at the operating point 33 being outside the active region and being capable to conduct the high transient currents.

According to another embodiment of the assembly 1, in the active short circuit mode, the switching elements 4 connected to the high potential of the DC link are provided to be in the conducting switching state, and the switching elements 5 connected to the low potential of the DC link are provided to be in the blocking switching state. Thus, the boosting units 10 are connected to the switching elements 4 instead of being connected to the switching elements 5.

According to yet another embodiment of the assembly 1, the short circuit unit 16 is configured to override or ignore the signals from the pulsing unit 13 in the active short circuit mode instead of inhibiting them.

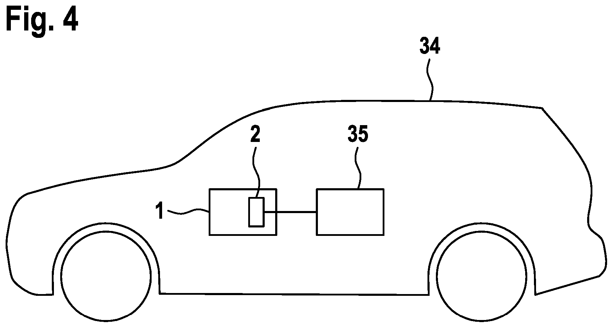

Fig. 4 is a schematic drawing of an embodiment of a vehicle 34, comprising an assembly 1 according to one of the above-mentioned embodiments. The assembly 1 is configured to drive the vehicle 34, when the inverter's 2 DC link is supplied by a high voltage battery 35.

## Claims

1. Inverter (2), in particular for an electric machine (3), comprising a DC link, a plurality of voltage-controlled switching elements (4, 5) being arranged into half bridges, an active region detection unit (11) configured to detect an operation of a switching element (4, 5) in an active region and a controller (12) with a pulsing unit (13) configured to control the switching elements (4, 5) to provide a multiphase AC output (6) in a pulsing mode of the switching elements (4, 5), wherein the controller (12) comprises a short circuit unit (16) configured
- to put the switching elements (4, 5) into an active short circuit mode, if the operation in the active region is detected by the active region detection unit (11), wherein if the switching element (4), for which the operation in the active region has been detected, is connected to the high potential of the DC link, the switching elements (4, 5) of the inverter (2) are put into a full active short circuit mode, which includes switching the switching element (4, 5), for which the operation in the active region has been detected, to a blocking state and wherein if the switching element (5), for which the operation in the active region has been detected, is connected to the low potential of the DC link, the switching elements (4, 5) of the inverter (2) are put into a partial active short circuit mode, which includes switching the switching element (5), for which the operation in the active region has been detected, to a blocking state and
- to set a value of a voltage provided to a control terminal (9) of a switching element (5) connected to the low potential of the DC link, the provided voltage having a first absolute value in the pulsing mode and a second absolute value being higher than the first absolute value in the active short circuit mode,
wherein the switching elements (4, 5) adopt the full active short circuit, when all switching elements (4) connected to the high potential are switched to their blocking state and all switching elements (5) connected to the low potential are switched to their conducting state, wherein the partial active short circuit is adopted when the switching elements (4, 5) of the half bridge having the switching element (5), for which the operation in the active region has been detected, are in the blocking state and, in the other half bridges, the switching elements (4) connected to the high potential are switched to their blocking state and the switching elements (5) connected to the low potential are switched to their conducting state.

2. Inverter (2), in particular for an electric machine (3), comprising a DC link, a plurality of voltage-controlled switching elements (4, 5) being arranged into half bridges, an active region detection unit (11) configured to detect an operation of a switching element (4, 5) in an active region and a controller (12) with a pulsing unit (13) configured to control the switching elements (4, 5) to provide a multiphase AC output (6) in a pulsing mode of the switching elements (4, 5), wherein the controller (12) comprises a short circuit unit (16) configured
- to put the switching elements (4, 5) into an active short circuit mode, if the operation in the active region is detected by the active region detection unit (11), wherein if the switching element (5), for which the operation in the active region has been detected, is connected to the low potential of the DC link, the switching elements (4, 5) of the inverter (2) are put into a full active short circuit mode, which includes switching the switching element (4, 5), for which the operation in the active region has been detected, to a blocking state and wherein if the switching element (4), for which the operation in the active region has been detected, is connected to the high potential of the DC link, the switching elements (4, 5) of the inverter (2) are put into a partial active short circuit mode, which includes switching the switching element (4), for which the operation in the active region has been detected, to a blocking state and
- to set a value of a voltage provided to a control terminal (9) of a switching element (4) connected to the high potential of the DC link, the provided voltage having a first absolute value in the pulsing mode and a second absolute value being higher than the first absolute value in the active short circuit mode,
wherein the switching elements (4, 5) adopt the full active short circuit, when all switching elements (5) connected to the low potential are switched to their blocking state and all switching elements (4) connected to the high potential are switched to their conducting state, wherein the partial active short circuit is adopted when the switching elements (4, 5) of the half bridge having the switching element (4), for which the operation in the active region has been detected, are in the blocking state and, in the other half bridges, the switching elements (5) connected to the low potential are switched to their blocking state and the switching elements (4) connected to the high potential are switched to their conducting state.

3. Inverter (2) according to claim 1 or 2, wherein the controller (12) is configured to override, ignore or inhibit signals from the pulsing unit (13) when the short circuit unit (16) is triggered to put the switching elements (4, 5) into the active short circuit mode.

4. Inverter (2) according to any of the preceding claims, wherein the second absolute value is at least 5 %, particularly at least 10%, higher than the first absolute value.

5. Inverter (2) according to any of the preceding claims, wherein the control terminal (9) of each switching element (5) designated to be conducting in the active short circuit mode is connected to a boosting unit (10) comprising an energy source (24) connectable to the control terminal (9) for providing the voltage with the second absolute value.

6. Inverter (2) according to claim 5, wherein the energy source (24) comprises an energy storage (25) chargeable to an amount of charge for reaching the second absolute value on the control terminal (9).

7. Inverter (2) according to claim 6, wherein the energy storage (25) is dimensioned such that a capacity (28) of the control terminal (9) with a certain capacitance being charged to the first absolute value is charged to the second absolute value.

8. Inverter (2) according to claim 6 or 7, wherein the energy storage (25) is dimensioned such that the second absolute value is held for 500 milliseconds.

9. Inverter (2) according to any of claims 5 to 8, wherein the boosting unit (10) comprises a switch (26) configured to connect the energy source (24) to the control terminal (9) when putting the switching elements (4, 5) in the active short circuit mode.

10. Inverter (2) according to any of claims 5 to 9, wherein the control terminal (9) is connected to a driver unit (8), wherein the driver unit (8) is configured to amplify signals from the pulsing unit (13), wherein the energy source (24) is connectable to a node (27) between the driver unit (8) and the control terminal (9).

11. Inverter (2) according to any of the preceding claims, wherein the controller (12) comprises a failure detection unit (14) configured to detect a failure state of the inverter (2) and to trigger the short circuit unit (16) to put the switching elements (4, 5) into the active short circuit mode if a failure is detected.

12. Assembly (1) comprising :
- an electric machine (3), in particular for a vehicle (34), comprising stator windings and
- an inverter (2) according to any of claims 1 to 11 configured to provide the AC output (6) to the stator windings.

13. Vehicle (34), comprising an assembly (1) according to claim 12.

14. Method for operating an inverter (2), in particular for an electric machine (3), comprising a DC link, a plurality of voltage-controlled switching elements (4, 5) being arranged into half bridges, wherein the switching elements (4, 5) are controlled to provide a multiphase AC output (6) in a pulsing operation mode of the switching elements (4, 5), wherein
- the switching elements (4, 5) are put into an active short circuit mode, if an operation of a switching element (4, 5) in an active region is detected, wherein if the switching element (4), for which the operation in the active region has been detected, is connected to the high potential of the DC link, the switching elements (4, 5) of the inverter (2) are put into a full active short circuit mode, which includes switching the switching element (4, 5), for which the operation in the active region has been detected, to a blocking state and wherein if the switching element (5), for which the operation in the active region has been detected, is connected to the low potential of the DC link, the switching elements (4, 5) of the inverter (2) are put into a partial active short circuit mode, which includes switching the switching element (5), for which the operation in the active region has been detected, to a blocking state and
- a value of a voltage provided to a control terminal (9) of a switching element (5) connected to the low potential of the DC link is set, the provided voltage having a first absolute value in the pulsing mode and a second absolute value being higher than the first absolute value in the active short circuit mode,
wherein the switching elements (4, 5) adopt the full active short circuit, when all switching elements (4) connected to the high potential are switched to their blocking state and all switching elements (5) connected to the low potential are switched to their conducting state, wherein the partial active short circuit is adopted when the switching elements (4, 5) of the half bridge having the switching element, for which the operation in the active region has been detected, are in the blocking state and, in the other half bridges, the switching elements (4) connected to the high potential are switched to their blocking state and the switching elements (5) connected to the low potential are switched to their conducting state.

15. Method for operating an inverter (2), in particular for an electric machine (3), comprising a DC link, a plurality of voltage-controlled switching elements (4, 5) being arranged into half bridges, wherein the switching elements (4, 5) are controlled to provide a multiphase AC output (6) in a pulsing operation mode of the switching elements (4, 5), wherein
- the switching elements (4, 5) are put into an active short circuit mode, if an operation of a switching element (4, 5) in an active region is detected, wherein if the switching element (5), for which the operation in the active region has been detected, is connected to the low potential of the DC link, the switching elements (4, 5) of the inverter (2) are put into a full active short circuit mode, which includes switching the switching element (4, 5), for which the operation in the active region has been detected, to a blocking state and wherein if the switching element (4), for which the operation in the active region has been detected, is connected to the high potential of the DC link, the switching elements (4, 5) of the inverter (2) are put into a partial active short circuit mode, which includes switching the switching element (4), for which the operation in the active region has been detected, to a blocking state and
- a value of a voltage provided to a control terminal (9) of a switching element (4) connected to the high potential of the DC link is set, the provided voltage having a first absolute value in the pulsing mode and a second absolute value being higher than the first absolute value in the active short circuit mode,
wherein the switching elements (4, 5) adopt the full active short circuit, when all switching elements (5) connected to the low potential are switched to their blocking state and all switching elements connected (4) to the high potential are switched to their conducting state, wherein the partial active short circuit is adopted when the switching elements (4, 5) of the half bridge having the switching element, for which the operation in the active region has been detected, are in the blocking state and, in the other half bridges, the switching elements (5) connected to the low potential are switched to their blocking state and the switching elements (4) connected to the high potential are switched to their conducting state.

## Patentansprüche

1. Wechselrichter (2), insbesondere für eine elektrische Maschine (3), umfassend: eine DC-Verbindung, mehrere spannungsgesteuerte Schaltelemente (4, 5), die zu Halbbrücken angeordnet sind, eine Aktivregion-Detektionseinheit (11), ausgelegt zum Detektieren eines Betriebs eines Schaltelements (4, 5) in einer aktiven Region, und eine Steuerung (12) mit einer Pulseinheit (13), ausgelegt zum Steuern der Schaltelemente (4, 5) zur Bereitstellung einer Mehrphasen-AC-Ausgabe (6) in einem Pulsmodus der Schaltelemente (4, 5), wobei die Steuerung (12) eine Kurzschlusseinheit (16) umfasst, ausgelegt zum
- Versetzen der Schaltelemente (4, 5) in einen Aktiv-Kurzschlussmodus, wenn der Betrieb in der aktiven Region durch die Aktivregion-Detektionseinheit (11) detektiert wird, wobei, wenn das Schaltelement (4), für das der Betrieb in der aktiven Region detektiert wurde, mit dem hohen Potential der DC-Verbindung verbunden ist, die Schaltelemente (4, 5) des Wechselrichters (2) in einen Voll-Aktiv-Kurzschlussmodus versetzt werden, der Schalten des Schaltelements (4, 5), für das Betrieb in der aktiven Region detektiert wurde, in einen Sperrzustand umfasst, und wobei, wenn das Schaltelement (5), für das der Betrieb in der aktiven Region detektiert wurde, mit dem niedrigen Potential der DC-Verbindung verbunden ist, die Schaltelemente (4, 5) des Wechselrichters (2) in einen Partial-Aktiv-Kurzschlussmodus versetzt werden, der Schalten des Schaltelements (5), für das Betrieb in der aktiven Region detektiert wurde, in einen Sperrzustand umfasst, und
- Setzen eines Werts einer Spannung, die einem Steueranschluss (9) eines Schaltelements (5), das mit dem niedrigen Potential der DC-Verbindung verbunden ist, zugeführt wird, wobei die zugeführte Spannung in dem Pulsmodus einen ersten Absolutwert und in dem Aktiv-Kurzschlussmodus einen zweiten Absolutwert, der höher als der erste Absolutwert ist, aufweist,
wobei die Schaltelemente (4, 5) den Voll-Aktiv-Kurzschluss annehmen, wenn alle mit dem hohen Potential verbundenen Schaltelemente (4) in ihren Sperrzustand geschaltet werden und alle mit dem niedrigen Potential verbundenen Schaltelemente (5) in ihren leitenden Zustand geschaltet werden, wobei der Partial-Aktiv-Kurzschluss angenommen wird, wenn sich die Schaltelemente (4, 5) der Halbbrücke mit dem Schaltelement (5), für das der Betrieb in der aktiven Region detektiert wurde, in dem sperrenden Zustand befinden, und in den anderen Halbbrücken die mit dem hohen Potential verbundenen Schaltelemente (4) in ihren sperrenden Zustand geschaltet werden und die mit dem niedrigen Potential verbundenen Schaltelemente (5) in ihren leitenden Zustand geschaltet werden.

2. Wechselrichter (2), insbesondere für eine elektrische Maschine (3), umfassend: eine DC-Verbindung, mehrere spannungsgesteuerte Schaltelemente (4, 5), die zu Halbbrücken angeordnet sind, eine Aktivregion-Detektionseinheit (11), ausgelegt zum Detektieren eines Betriebs eines Schaltelements (4, 5) in einer aktiven Region, und eine Steuerung (12) mit einer Pulseinheit (13), ausgelegt zum Steuern der Schaltelemente (4, 5) zur Bereitstellung einer Mehrphasen-AC-Ausgabe (6) in einem Pulsmodus der Schaltelemente (4, 5), wobei die Steuerung (12) eine Kurzschlusseinheit (16) umfasst, ausgelegt zum
- Versetzen der Schaltelemente (4, 5) in einen Aktiv-Kurzschlussmodus, wenn der Betrieb in der aktiven Region durch die Aktivregion-Detektionseinheit (11) detektiert wird, wobei, wenn das Schaltelement (5), für das der Betrieb in der aktiven Region detektiert wurde, mit dem niedrigen Potential der DC-Verbindung verbunden ist, die Schaltelemente (4, 5) des Wechselrichters (2) in einen Voll-Aktiv-Kurzschlussmodus versetzt werden, der Schalten des Schaltelements (4, 5), für das Betrieb in der aktiven Region detektiert wurde, in einen Sperrzustand umfasst, und wobei, wenn das Schaltelement (4), für das der Betrieb in der aktiven Region detektiert wurde, mit dem hohen Potential der DC-Verbindung verbunden ist, die Schaltelemente (4, 5) des Wechselrichters (2) in einen Partial-Aktiv-Kurzschlussmodus versetzt werden, der Schalten des Schaltelements (4), für das Betrieb in der aktiven Region detektiert wurde, in einen Sperrzustand umfasst, und
- Setzen eines Werts einer Spannung, die einem Steueranschluss (9) eines Schaltelements (4), das mit dem hohen Potential der DC-Verbindung verbunden ist, zugeführt wird, wobei die zugeführte Spannung in dem Pulsmodus einen ersten Absolutwert und in dem Aktiv-Kurzschlussmodus einen zweiten Absolutwert, der höher als der erste Absolutwert ist, aufweist,
wobei die Schaltelemente (4, 5) den Voll-Aktiv-Kurzschluss annehmen, wenn alle mit dem niedrigen Potential verbundenen Schaltelemente (5) in ihren Sperrzustand geschaltet werden und alle mit dem hohen Potential verbundenen Schaltelemente (4) in ihren leitenden Zustand geschaltet werden, wobei der Partial-Aktiv-Kurzschluss angenommen wird, wenn sich die Schaltelemente (4, 5) der Halbbrücke mit dem Schaltelement (4), für das der Betrieb in der aktiven Region detektiert wurde, in dem sperrenden Zustand befinden, und in den anderen Halbbrücken die mit dem niedrigen Potential verbundenen Schaltelemente (5) in ihren sperrenden Zustand geschaltet werden und die mit dem hohen Potential verbundenen Schaltelemente (4) in ihren leitenden Zustand geschaltet werden.

3. Wechselrichter (2) nach Anspruch 1 oder 2, wobei die Steuerung (12) ausgelegt ist zum Übersteuern, Ignorieren oder Deaktivieren von Signalen von der Pulseinheit (13), wenn die Kurzschlusseinheit (16) dazu getriggert wird, die Schaltelemente (4, 5) in den Aktiv-Kurzschlussmodus zu versetzen.

4. Wechselrichter (2) nach einem der vorhergehenden Ansprüche, wobei der zweite Absolutwert mindestens 5%, insbesondere mindestens 10%, höher als der erste Absolutwert ist.

5. Wechselrichter (2) nach einem der vorhergehenden Ansprüche, wobei der Steueranschluss (9) jedes Schaltelements (5) das dafür designiert ist, in dem Aktiv-Kurzschlussmodus leitend zu sein, mit einer Boost-Einheit (10) verbunden ist, die eine Energiequelle (24) umfasst, die mit dem Steueranschluss (9) verbindbar ist, um die Spannung mit dem zweiten Absolutwert bereitzustellen.

6. Wechselrichter (2) nach Anspruch 5, wobei die Energiequelle (24) eine Energiespeicherung (25) umfasst, die auf eine Ladungsmenge zum Erreichen des zweiten Absolutwerts an dem Steueranschluss (9) ladbar ist.

7. Wechselrichter (2) nach Anspruch 6, wobei die Energiespeicherung (25) so dimensioniert ist, dass eine Kapazität (28) des Steueranschlusses (9), mit einer bestimmten Kapazität, die auf den ersten Absolutwert geladen wird, auf den zweiten Absolutwert geladen wird.

8. Wechselrichter (2) nach Anspruch 6 oder 7, wobei die Energiespeicherung (25) so dimensioniert ist, dass der zweite Absolutwert 500 Millisekunden lang gehalten wird.

9. Wechselrichter (2) nach einem der Ansprüche 5 bis 8, wobei die Boost-Einheit (10) einen Schalter (26) umfasst, der dafür ausgelegt ist, die Energiequelle (24) beim Versetzen der Schaltelemente (4, 5) in den Aktiv-Kurzschlussmodus mit dem Steueranschluss (9) zu verbinden.

10. Wechselrichter (2) nach einem der Ansprüche 5 bis 9, wobei der Steueranschluss (9) mit einer Treibereinheit (8) verbunden ist, wobei die Treibereinheit (8) dafür ausgelegt ist, Signale von der Pulseinheit (13) zu verstärken, wobei die Energiequelle (24) mit einem Knoten (27) zwischen der Treibereinheit (8) und dem Steueranschluss (9) verbindbar ist.

11. Wechselrichter (2) nach einem der vorhergehenden Ansprüche, wobei die Steuerung (12) eine Ausfalldetektionseinheit (14) umfasst, die dafür ausgelegt ist, einen Ausfallzustand des Wechselrichters (2) zu detektieren und die Kurzschlusseinheit (16) dazu zu triggern, die Schaltelemente (4, 5) in den Aktiv-Kurzschlussmodus zu versetzen, wenn ein Ausfall detektiert wird.

12. Baugruppe (1), umfassend:
- eine elektrische Maschine (3), insbesondere für ein Fahrzeug (34), die Statorwicklungen umfasst, und
- einen Wechselrichter (2) nach einem der Ansprüche 1 bis 11, der dafür ausgelegt ist, die AC-Ausgabe (6) den Statorwicklungen zuzuführen.

13. Fahrzeug (34), das eine Baugruppe (1) nach Anspruch 12 umfasst.

14. Verfahren zum Betrieb eines Wechselrichters (2), insbesondere für eine elektrische Maschine (3), der eine DC-Verbindung, mehrere spannungsgesteuerte Schaltelemente (4, 5), die zu Halbbrücken angeordnet sind, wobei die Schaltelemente (4, 5) gesteuert werden, um in einem Pulsbetriebsmodus der Schaltelemente (4, 5) eine Mehrphasen-AC-Ausgabe (6) bereitzustellen, umfasst, wobei
- die Schaltelemente (4, 5) in einen Aktiv-Kurzschlussmodus versetzt werden, wenn ein Betrieb eines Schaltelements (4, 5) in einer aktiven Region detektiert wird, wobei, wenn das Schaltelement (4), für das der Betrieb in der aktiven Region detektiert wurde, mit dem hohen Potential der DC-Verbindung verbunden ist, die Schaltelemente (4, 5) des Wechselrichters (2) in einen Voll-Aktiv-Kurzschlussmodus versetzt werden, der Schalten des Schaltelements (4, 5), für das Betrieb in der aktiven Region detektiert wurde, in einen Sperrzustand umfasst, und wobei, wenn das Schaltelement (5), für das der Betrieb in der aktiven Region detektiert wurde, mit dem niedrigen Potential der DC-Verbindung verbunden ist, die Schaltelemente (4, 5) des Wechselrichters (2) in einen Partial-Aktiv-Kurzschlussmodus versetzt werden, der Schalten des Schaltelements (5), für das Betrieb in der aktiven Region detektiert wurde, in einen Sperrzustand umfasst, und
- ein Wert einer einem Steueranschluss (9) eines mit dem niedrigen Potential der DC-Verbindung verbundenen Schaltelements (5) zugeführten Spannung gesetzt wird, wobei die zugeführte Spannung in dem Pulsmodus einen ersten Absolutwert und in dem Aktiv-Kurzschlussmodus einen zweiten Absolutwert, der höher als der erste Absolutwert ist, aufweist
wobei die Schaltelemente (4, 5) den Voll-Aktiv-Kurzschluss annehmen, wenn alle mit dem hohen Potential verbundenen Schaltelemente (4) in ihren Sperrzustand geschaltet werden und alle mit dem niedrigen Potential verbundenen Schaltelemente (5) in ihren leitenden Zustand geschaltet werden, wobei der Partial-Aktiv-Kurzschluss angenommen wird, wenn sich die Schaltelemente (4, 5) der Halbbrücke mit dem Schaltelement, für das der Betrieb in der aktiven Region detektiert wurde, in dem sperrenden Zustand befinden, und in den anderen Halbbrücken die mit dem hohen Potential verbundenen Schaltelemente (4) in ihren sperrenden Zustand geschaltet werden und die mit dem niedrigen Potential verbundenen Schaltelemente (5) in ihren leitenden Zustand geschaltet werden.

15. Verfahren zum Betrieb eines Wechselrichters (2), insbesondere für eine elektrische Maschine (3), der eine DC-Verbindung, mehrere spannungsgesteuerte Schaltelemente (4, 5), die zu Halbbrücken angeordnet sind, wobei die Schaltelemente (4, 5) gesteuert werden, um in einem Pulsbetriebsmodus der Schaltelemente (4, 5) eine Mehrphasen-AC-Ausgabe (6) bereitzustellen, umfasst, wobei
- die Schaltelemente (4, 5) in einen Aktiv-Kurzschlussmodus versetzt werden, wenn ein Betrieb eines Schaltelements (4, 5) in einer aktiven Region detektiert wird, wobei, wenn das Schaltelement (5), für das der Betrieb in der aktiven Region detektiert wurde, mit dem niedrigen Potential der DC-Verbindung verbunden ist, die Schaltelemente (4, 5) des Wechselrichters (2) in einen Voll-Aktiv-Kurzschlussmodus versetzt werden, der Schalten des Schaltelements (4, 5), für das Betrieb in der aktiven Region detektiert wurde, in einen Sperrzustand umfasst, und wobei, wenn das Schaltelement (4), für das der Betrieb in der aktiven Region detektiert wurde, mit dem hohen Potential der DC-Verbindung verbunden ist, die Schaltelemente (4, 5) des Wechselrichters (2) in einen Partial-Aktiv-Kurzschlussmodus versetzt werden, der Schalten des Schaltelements (4), für das Betrieb in der aktiven Region detektiert wurde, in einen Sperrzustand umfasst, und
- ein Wert einer einem Steueranschluss (9) eines mit dem hohen Potential der DC-Verbindung verbundenen Schaltelements (4) zugeführten Spannung gesetzt wird, wobei die zugeführte Spannung in dem Pulsmodus einen ersten Absolutwert und in dem Aktiv-Kurzschlussmodus einen zweiten Absolutwert, der höher als der erste Absolutwert ist, aufweist,
wobei die Schaltelemente (4, 5) den Voll-Aktiv-Kurzschluss annehmen, wenn alle mit dem niedrigen Potential verbundenen Schaltelemente (5) in ihren Sperrzustand geschaltet werden und alle mit dem hohen Potential verbundenen Schaltelemente (4) in ihren leitenden Zustand geschaltet werden, wobei der Partial-Aktiv-Kurzschluss angenommen wird, wenn sich die Schaltelemente (4, 5) der Halbbrücke mit dem Schaltelement, für das der Betrieb in der aktiven Region detektiert wurde, in dem sperrenden Zustand befinden, und in den anderen Halbbrücken die mit dem niedrigen Potential verbundenen Schaltelemente (5) in ihren sperrenden Zustand geschaltet werden und die mit dem hohen Potential verbundenen Schaltelemente (4) in ihren leitenden Zustand geschaltet werden.

## Revendications

1. Onduleur (2), en particulier pour une machine électrique (3), comprenant une liaison à CC, une pluralité d'éléments de commutation (4, 5) commandés en tension agencés en demi-ponts, une unité de détection de région active (11) configurée pour détecter un fonctionnement d'un élément de commutation (4, 5) dans une région active et un contrôleur (12) avec une unité d'impulsion (13) configuré pour commander les éléments de commutation (4, 5) afin de fournir une sortie polyphasée à CA (6) dans un mode d'impulsion des éléments de commutation (4, 5), le contrôleur (12) comprenant une unité de court-circuit (16) configurée
- pour mettre les éléments de commutation (4, 5) dans un mode court-circuit actif, si le fonctionnement dans la région active est détecté par l'unité de détection de région active (11), dans lequel si l'élément de commutation (4), pour lequel le fonctionnement dans la région active a été détecté, est connecté au potentiel haut de la liaison à CC, les éléments de commutation (4, 5) de l'onduleur (2) sont mis dans un mode court-circuit actif intégral, lequel comporte la commutation de l'élément de commutation (4, 5), pour lequel le fonctionnement dans la région active a été détecté, à un état de blocage et si l'élément de commutation (5), pour lequel le fonctionnement dans la région active a été détecté, est connecté au potentiel bas de la liaison à CC, les éléments de commutation (4, 5) de l'onduleur (2) sont mis dans un mode court-circuit actif partiel, lequel comporte la commutation de l'élément de commutation (5), pour lequel le fonctionnement dans la région active a été détecté, à un état de blocage et
- pour définir une valeur d'une tension fournie à une borne de commande (9) d'un élément de commutation (5) connecté au potentiel bas de la liaison à CC, la tension fournie ayant une première valeur absolue dans le mode d'impulsion et une deuxième valeur absolue qui est supérieure à la première valeur absolue dans le mode court-circuit actif,
les éléments de commutation (4, 5) adoptant le court-circuit actif intégral, lorsque tous les éléments de commutation (4) connectés au potentiel haut sont commutés à leur état de blocage et tous les éléments de commutation (5) connectés au potentiel bas sont commutés à leur état de conduction, le court-circuit actif partiel étant adopté lorsque les éléments de commutation (4, 5) du demi-pont ayant l'élément de commutation (5), pour lequel le fonctionnement dans la région active a été détecté, sont dans l'état de blocage et, dans les autres demi-ponts, les éléments de commutation (4) connectés au potentiel haut sont commutés à leur état de blocage et les éléments de commutation (5) connectés au potentiel bas sont commutés à leur état de conduction.

2. Onduleur (2), en particulier pour une machine électrique (3), comprenant une liaison à CC, une pluralité d'éléments de commutation (4, 5) commandés en tension agencés en demi-ponts, une unité de détection de région active (11) configurée pour détecter un fonctionnement d'un élément de commutation (4, 5) dans une région active et un contrôleur (12) avec une unité d'impulsion (13) configuré pour commander les éléments de commutation (4, 5) afin de fournir une sortie polyphasée à CA (6) dans un mode d'impulsion des éléments de commutation (4, 5), le contrôleur (12) comprenant une unité de court-circuit (16) configurée
- pour mettre les éléments de commutation (4, 5) dans un mode court-circuit actif, si le fonctionnement dans la région active est détecté par l'unité de détection de région active (11), dans lequel si l'élément de commutation (5), pour lequel le fonctionnement dans la région active a été détecté, est connecté au potentiel bas de la liaison à CC, les éléments de commutation (4, 5) de l'onduleur (2) sont mis dans un mode court-circuit actif intégral, lequel comporte la commutation de l'élément de commutation (4, 5), pour lequel le fonctionnement dans la région active a été détecté, à un état de blocage et si l'élément de commutation (4), pour lequel le fonctionnement dans la région active a été détecté, est connecté au potentiel haut de la liaison à CC, les éléments de commutation (4, 5) de l'onduleur (2) sont mis dans un mode court-circuit actif partiel, lequel comporte la commutation de l'élément de commutation (4), pour lequel le fonctionnement dans la région active a été détecté, à un état de blocage et
- pour définir une valeur d'une tension fournie à une borne de commande (9) d'un élément de commutation (4) connecté au potentiel haut de la liaison à CC, la tension fournie ayant une première valeur absolue dans le mode d'impulsion et une deuxième valeur absolue qui est supérieure à la première valeur absolue dans le mode court-circuit actif,
les éléments de commutation (4, 5) adoptant le court-circuit actif intégral, lorsque tous les éléments de commutation (5) connectés au potentiel bas sont commutés à leur état de blocage et tous les éléments de commutation (4) connectés au potentiel haut sont commutés à leur état de conduction, le court-circuit actif partiel étant adopté lorsque les éléments de commutation (4, 5) du demi-pont ayant l'élément de commutation (4), pour lequel le fonctionnement dans la région active a été détecté, sont dans l'état de blocage et, dans les autres demi-ponts, les éléments de commutation (5) connectés au potentiel bas sont commutés à leur état de blocage et les éléments de commutation (4) connectés au potentiel haut sont commutés à leur état de conduction.

3. Onduleur (2) selon la revendication 1 ou 2 dans lequel le contrôleur (12) est configuré pour passer outre, ignorer ou inhiber des signaux en provenance de l'unité d'impulsion (13) lorsque l'unité de court-circuit (16) est déclenchée pour mettre les éléments de commutation (4, 5) dans le mode court-circuit actif.

4. Onduleur (2) selon l'une quelconque des revendications précédentes dans lequel la deuxième valeur absolue est au moins 5 %, plus particulièrement au moins 10 %, plus grande que la première valeur absolue.

5. Onduleur (2) selon l'une quelconque des revendications précédentes dans lequel la borne de commande (9) de chaque élément de commutation (5) désigné pour être conducteur dans le mode court-circuit actif est connectée à une unité d'amplification (10) comprenant une source d'énergie (24) pouvant être connectée à la borne de commande (9) pour fournir la tension avec la deuxième valeur absolue.

6. Onduleur (2) selon la revendication 5 dans lequel la source d'énergie (24) comprend un stockage d'énergie (25) pouvant être chargé à une quantité de charge pour atteindre la deuxième valeur absolue sur la borne de commande (9).

7. Onduleur (2) selon la revendication 6 dans lequel le stockage d'énergie (25) est dimensionné de telle sorte qu'un condensateur (28) de la borne de commande (9) avec une certaine capacité qui est chargé à la première valeur absolue est chargé à la deuxième valeur absolue.

8. Onduleur (2) selon la revendication 6 ou 7 dans lequel le stockage d'énergie (25) est dimensionné de telle sorte que la deuxième valeur absolue est maintenue pendant 500 millisecondes.

9. Onduleur (2) selon l'une quelconque des revendications 5 à 8 dans lequel l'unité d'amplification (10) comprend un commutateur (26) configuré pour connecter la source d'énergie (24) à la borne de commande (9) lors de la mise en mode court-circuit actif des éléments de commutation (4, 5).

10. Onduleur (2) selon l'une quelconque des revendications 5 à 9 dans lequel la borne de commande (9) est connectée à une unité de pilotage (8), l'unité de pilotage (8) étant configurée pour amplifier des signaux en provenance de l'unité d'impulsion (13), la source d'énergie (24) pouvant être connectée à un nœud (27) entre l'unité de pilotage (8) et la borne de commande (9) .

11. Onduleur (2) selon l'une quelconque des revendications précédentes dans lequel le contrôleur (12) comprend une unité de détection de défaillance (14) configurée pour détecter un état de défaillance de l'onduleur (2) et pour déclencher l'unité de court-circuit (16) pour mettre les éléments de commutation (4, 5) dans le mode court-circuit actif si une défaillance est détectée.

12. Ensemble (1) comprenant :
- une machine électrique (3), en particulier pour un véhicule (34), comprenant des enroulements de stator et
- un onduleur (2) selon l'une quelconque des revendications 1 à 11 configuré pour fournir la sortie à CA (6) aux enroulements de stator.

13. Véhicule (34), comprenant un ensemble (1) selon la revendication 12.

14. Procédé d'exploitation d'un onduleur (2), en particulier pour une machine électrique (3), comprenant une liaison à CC, une pluralité d'éléments de commutation (4, 5) commandés en tension agencés en demi-ponts, les éléments de commutation (4, 5) étant commandés afin de fournir une sortie polyphasée à CA (6) dans un mode de fonctionnement à impulsion des éléments de commutation (4, 5), dans lequel
- les éléments de commutation (4, 5) sont mis dans un mode court-circuit actif, si un fonctionnement d'un élément de commutation (4, 5) dans une région active est détecté, dans lequel si l'élément de commutation (4), pour lequel le fonctionnement dans la région active a été détecté, est connecté au potentiel haut de la liaison à CC, les éléments de commutation (4, 5) de l'onduleur (2) sont mis dans un mode court-circuit actif intégral, lequel comporte la commutation de l'élément de commutation (4, 5), pour lequel le fonctionnement dans la région active a été détecté, à un état de blocage et si l'élément de commutation (5), pour lequel le fonctionnement dans la région active a été détecté, est connecté au potentiel bas de la liaison à CC, les éléments de commutation (4, 5) de l'onduleur (2) sont mis dans un mode court-circuit actif partiel, lequel comporte la commutation de l'élément de commutation (5), pour lequel le fonctionnement dans la région active a été détecté, à un état de blocage et
- une valeur d'une tension fournie à une borne de commande (9) d'un élément de commutation (5) connecté au potentiel bas de la liaison à CC étant définie, la tension fournie ayant une première valeur absolue dans le mode d'impulsion et une deuxième valeur absolue qui est supérieure à la première valeur absolue dans le mode court-circuit actif,
les éléments de commutation (4, 5) adoptant le court-circuit actif intégral, lorsque tous les éléments de commutation (4) connectés au potentiel haut sont commutés à leur état de blocage et tous les éléments de commutation (5) connectés au potentiel bas sont commutés à leur état de conduction, le court-circuit actif partiel étant adopté lorsque les éléments de commutation (4, 5) du demi-pont ayant l'élément de commutation, pour lequel le fonctionnement dans la région active a été détecté, sont dans l'état de blocage et, dans les autres demi-ponts, les éléments de commutation (4) connectés au potentiel haut sont commutés à leur état de blocage et les éléments de commutation (5) connectés au potentiel bas sont commutés à leur état de conduction.

15. Procédé d'exploitation d'un onduleur (2), en particulier pour une machine électrique (3), comprenant une liaison à CC, une pluralité d'éléments de commutation (4, 5) commandés en tension agencés en demi-ponts, les éléments de commutation (4, 5) étant commandés afin de fournir une sortie polyphasée à CA (6) dans un mode de fonctionnement à impulsion des éléments de commutation (4, 5), dans lequel
- les éléments de commutation (4, 5) sont mis dans un mode court-circuit actif, si un fonctionnement d'un élément de commutation (4, 5) dans une région active est détecté, dans lequel si l'élément de commutation (5), pour lequel le fonctionnement dans la région active a été détecté, est connecté au potentiel bas de la liaison à CC, les éléments de commutation (4, 5) de l'onduleur (2) sont mis dans un mode court-circuit actif intégral, lequel comporte la commutation de l'élément de commutation (4, 5), pour lequel le fonctionnement dans la région active a été détecté, à un état de blocage et si l'élément de commutation (4), pour lequel le fonctionnement dans la région active a été détecté, est connecté au potentiel haut de la liaison à CC, les éléments de commutation (4, 5) de l'onduleur (2) sont mis dans un mode court-circuit actif partiel, lequel comporte la commutation de l'élément de commutation (4), pour lequel le fonctionnement dans la région active a été détecté, à un état de blocage et
- une valeur d'une tension fournie à une borne de commande (9) d'un élément de commutation (4) connecté au potentiel haut de la liaison à CC étant définie, la tension fournie ayant une première valeur absolue dans le mode d'impulsion et une deuxième valeur absolue qui est supérieure à la première valeur absolue dans le mode court-circuit actif,
les éléments de commutation (4, 5) adoptant le court-circuit actif intégral, lorsque tous les éléments de commutation (5) connectés au potentiel bas sont commutés à leur état de blocage et tous les éléments de commutation (4) connectés au potentiel haut sont commutés à leur état de conduction, le court-circuit actif partiel étant adopté lorsque les éléments de commutation (4, 5) du demi-pont ayant l'élément de commutation, pour lequel le fonctionnement dans la région active a été détecté, sont dans l'état de blocage et, dans les autres demi-ponts, les éléments de commutation (5) connectés au potentiel bas sont commutés à leur état de blocage et les éléments de commutation (4) connectés au potentiel haut sont commutés à leur état de conduction.
